# EUROPÄISCHE PATENTANMELDUNG

(11) **EP 3 790 197 A1**
(43) Veröffentlichungstag der Anmeldung: **10.03.2021**
(21) Anmeldenummer: 20000318.4
(22) Anmeldetag: 02.09.2020
(51) Int. Cl.: H03K 19/17736

(54) **ANORDNUNG VON SWITCHBOXEN**

(30) Priorität: 05.09.2019 DE 102019006292
(71) Anmelder: PatForce GmbH, 50670 Köln (DE)
(72) Erfinder:

(57) **Zusammenfassung**

Switchboxen werden insbesondere in integrierten Schaltungen mit programmierbarer Logik (z.B. FPGAs) verwendet. Sie dienen dazu, konfigurierbare Signalwege zwischen Logikblöcken herzustellen. Dabei ist es besonders wichtig eine effiziente Struktur zu benutzen, d.h. eine Struktur deren Chipfläche möglichst klein ist und die in der Lage ist, kurze und schnelle Signalwege zu realisieren. Aufgabe der vorliegenden Erfindung ist es den Aufwand für die Verbindungsstrukturen deutlich zu verringern und dabei trotzdem eine gute Routebarkeit zu erhalten. Dies wird dadurch erreicht, dass auf jeder Koordinatenposition ein CLB vorhanden ist, aber nicht auf jeder Koordinatenposition eine Switchbox (SB) angeordnet ist. Besonders vorteilhaft ist es die SBs schachbrettartig anzuordnen und auch zwei verschieden große SBs zu verwenden, die in einer übergeordneten Schachbrettstruktur angeordnet sind.

## Beschreibung

Switchboxen werden insbesondere in integrierten Schaltungen mit programmierbarer Logik (z.B. FPGAs) verwendet. Sie dienen dazu, konfigurierbare Signalwege zwischen Logikblöcken herzustellen. Dabei ist es besonders wichtig eine effiziente Struktur zu benutzen, d.h. eine Struktur deren Chipfläche möglichst klein ist und die in der Lage ist, kurze und schnelle Signalwege zu erreichen.

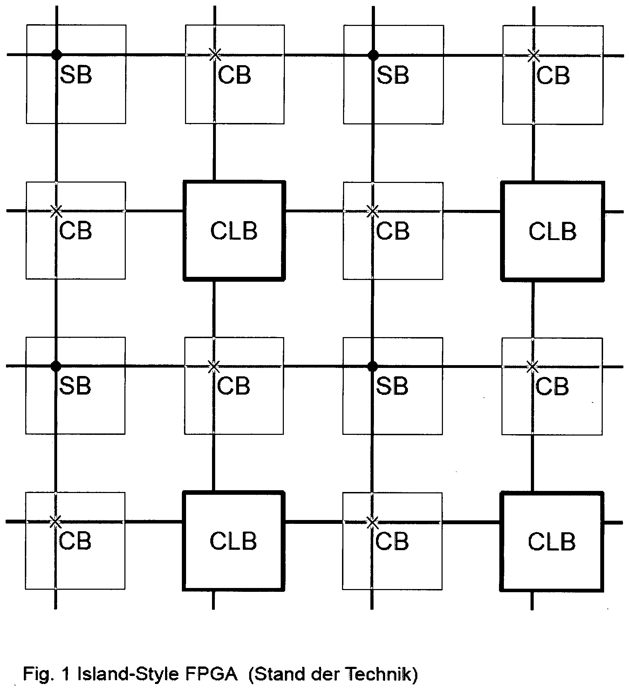

Nach dem Stand der Technik (Fig. 1) ist die typische Architektur eines FPGAs eine sog. "Island-Stile" Topologie. Hier gibt es drei verschiedene Schaltungsteile:
1. Configurable Logic Blocks (CLB)
2. Connectbox (CB)
3. Switchbox (SB)

Charakteristisch ist, dass für jeden CLB auch eine Switchbox vorhanden ist. Bei den CBs sind sogar in der Regel zwei pro Switchbox vorhanden.

Dies führt zu Strukturen in denen der Aufwand für die Verbindungselemente der Schaltung den Aufwand für die eigentliche Logik deutlich übersteigt.

Aufgabe der vorliegenden Erfindung ist es den Aufwand für die Verbindungsstrukturen deutlich zu verringern und dabei trotzdem eine gute Routebarkeit zu erhalten.

Diese Aufgabe wird erfindungsgemäß durch die kennzeichnenden Merkmale der Patentansprüche gelöst.

Hierbei wird nach Anspruch 1 vorgeschlagen dass in jeder Koordinatenrichtung Gitterkoordinaten vorhanden sind, bei denen einem Configurable Logic Block (CLB) keine Switchbox zugeordnet ist und damit Gitterkoordinaten von Switchboxen frei bleiben.

Da auf jeder Gitterkoordinate entsprechend der Erfindung ein CLB angeordnet ist, ist auch die Anzahl der Gitterkoordinaten mit SBs viel geringer ist als die Anzahl der CLBs. In der Regel werden nur 30-70 % SBs gegenüber CLBs verwendet (Anspruch 2).

Besonders vorteilhaft ist es nach Anspruch 3, wenn die Anzahl der Gitterkoordinaten mit SBs halb so groß ist wie die Anzahl der CLBs.

Wie im weiteren noch beschrieben, ist es entsprechend Anspruch 4, besonders für das Routing und die Erreichbarkeit von CLBs vorteilhaft, wenn diese schachbrettartig angeordnet sind. Dies führt dazu, dass in jeder Koordinatenrichtung abwechselnd eine Position mit einer SB und eine Position ohne SB vorhanden ist.

Nach Anspruch 5 sind SBs oder CBs parallel zu den Koordinatenachsen verbunden und jeweils mindestens mit einer diagonal angeordneten Switchbox verbunden.

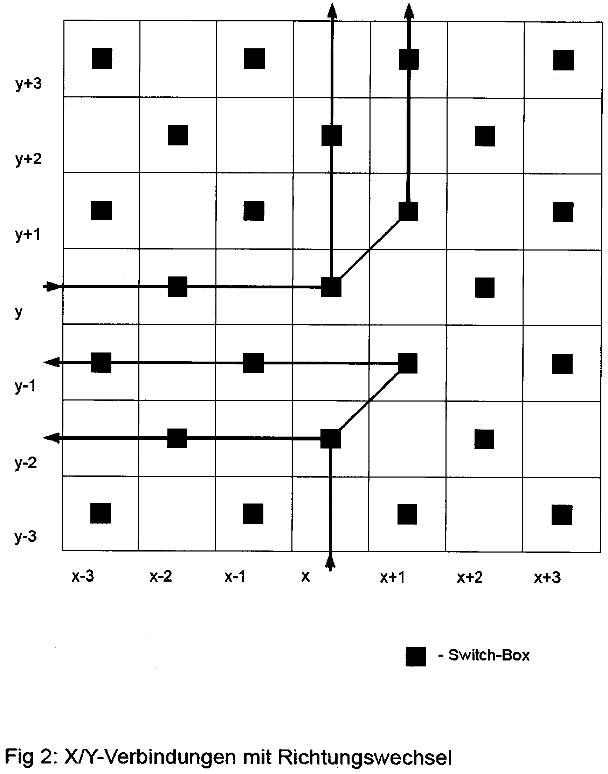

Obwohl die SBs nicht an jeder Koordinatenkreuzung vorhanden sind, ist ein Richtungswechsel von jeder Koordinate auf jede andere Koordinate in jeder Richtung möglich. Auf Kreuzungspunkten ohne SBs werden zwei SBs diagonal verbunden. Dies ist beispielhaft in Fig. 2 gezeigt.

Der Schaltungsaufwand lässt sich entsprechend Anspruch 6 weiter reduzieren, wenn mindestens zwei unterschiedliche Arten oder Größen von Switchboxen verwendet werden.

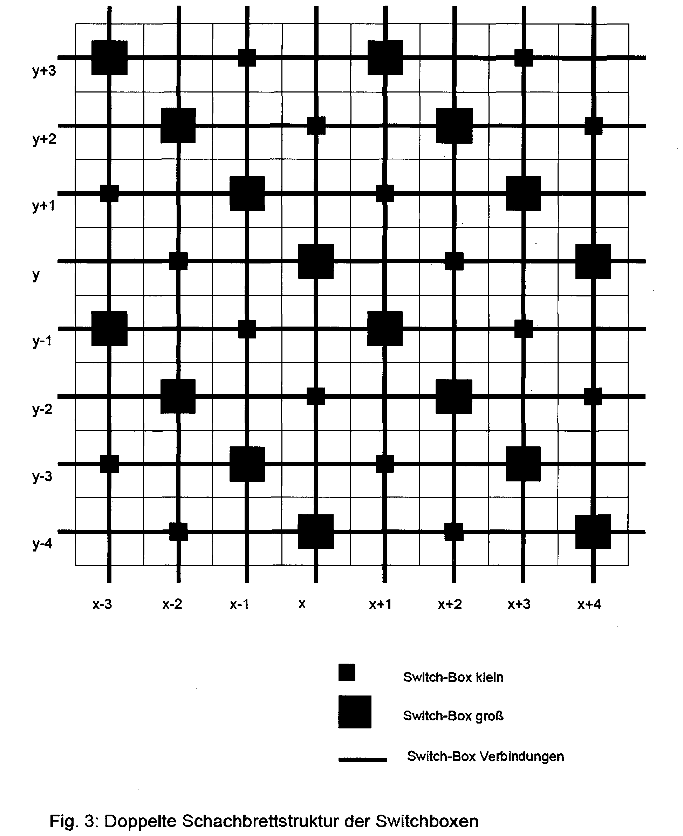

Hierbei ist es entsprechend Anspruch 7 vorteilhaft, in einer Art übergeordneten Schachbrettstruktur abwechselnd eine große und eine kleine Switchboxen zu verwenden, was Fig. 3 zeigt.

Anspruch 8 zeigt eine Anordnung bei der die Ausgänge von CLBs in SBs einspeisen, so dass die Ausgangssignale in jeder Koordinatenrichtung zur Verfügung stehen.

Beschreibung der Zeichnungen:
Fig.1: Island-Style FPGA (Stand der Technik)
   Die Zeichnung zeigt eine Anordnung von CLBs, CBs und SBs nach dem Stand der Technik. Jedem CLB sind zwei CBs und eine SB zugeordnet. Zur Vereinfachung sind Signalbündel nur als eine Leitung gezeigt.
Fig 2: X/Y-Verbindungen mit Richtungswechsel
   Die Zeichnung zeigt eine schachbrettartige Anordnung von Switchboxen. Ferner werden Verbindungen mit Richtungswechsel zwischen X- und Y-Richtung gezeigt. Es wird deutlich, dass von jeder Koordinate auf jede Koordinate in jeder Richtung eine Verbindung möglich ist, obwohl nicht in jedem Richtungswechselpunkt eine Switchbox vorhanden ist.
Fig. 3: Doppelte Schachbrettstruktur der Switchboxen
   Die Zeichnung zeigt schachbrettartig angeordnete Switchboxen, die aber verschiedene Größen haben. Kleine und große Switchboxen sind abwechselnd vorhanden und bilden damit eine weitere Schachbrettstruktur.

Es ist darauf zu achten, dass die Zeichnungen die Erfindung nur beispielhaft offenbaren. Die Erfindung ist nicht auf diese Anwendungsbeispiele begrenzt.

## Patentansprüche

1. Anordnung von Switchboxen **dadurch gekennzeichnet,**
**dass** in einer gitterartigen Anordnung in jeder Koordinatenrichtung Gitterkoordinaten vorhanden sind, bei denen einem Configurable Logic Block (CLB) keine Switchbox zugeordnet ist und damit Gitterkoordinaten von Switchboxen frei bleiben.

2. Anordnung von Switchboxen nach Anspruch 1 **dadurch gekennzeichnet,**
**dass** die Anzahl der Gitterkoordinaten mit Switchboxen viel geringer ist als die Anzahl der CLBs.

3. Anordnung von Switchboxen nach Anspruch 1 **dadurch gekennzeichnet,**
**dass** die Anzahl der Gitterkoordinaten mit Switchboxen halb so groß ist wie die Anzahl der CLBs.

4. Anordnung von Switchboxen nach einem oder mehreren der vorausgehenden Ansprüche **dadurch gekennzeichnet,**
**dass** die Anordnung schachbrettartig ist.

5. Anordnung von Switchboxen nach einem oder mehreren der vorausgehenden Ansprüche **dadurch gekennzeichnet,**
**dass** die Switch- oder Connectboxen parallel zu den Koordinatenachsen verbunden sind und jeweils mindestens eine Verbindung zu einer diagonal angeordneten Switchbox besteht.

6. Anordnung von Switchboxen nach einem oder mehreren der vorausgehenden Ansprüche **dadurch gekennzeichnet,**
**dass** mindestens zwei unterschiedliche Arten oder Größen von Switchboxen verwendet werden.

7. Anordnung von Switchboxen nach einem oder mehreren der vorausgehenden Ansprüche **dadurch gekennzeichnet,**
**dass** in einer Art übergeordneten Schachbrettstrüktur abwechselnd eine große und eine kleine Switchboxen verwendet wird.

8. Anordnung von Switchboxen nach einem oder mehreren der vorausgehenden Ansprüche **dadurch gekennzeichnet,**
**dass** die Ausgänge von CLBs in SBs einspeisen, so dass die Ausgangssignale in jeder Koordinatenrichtung zur Verfügung stehen.
